# EUROPEAN PATENT SPECIFICATION

(11) **EP 3 065 901 B1**
(45) Date of publication and mention of the grant of the patent: **14.07.2021**
(21) Application number: 14878691.6
(22) Date of filing: 28.10.2014
(51) Int. Cl.: B22F 3/14, B22F 7/02

(54) **METHOD FOR PREPARATION OF A SUPERALLOY HAVING A CRYSTALLOGRAPHIC TEXTURE CONTROLLED MICROSTRUCTURE BY ELECTRON BEAM MELTING**
VERFAHREN ZUR HERSTELLUNG EINER SUPERLEGIERUNG MIT EINER DURCH KRISTALLOGRAFISCHE TEXTUR GESTEUERTE MIKROSTRUKTUR DURCH ELEKTRONENSTRAHLSCHMELZEN
PROCÉDÉ DE PRÉPARATION D'UN SUPERALLIAGE PRÉSENTANT UNE MICROSTRUCTURE CONTRÔLÉE À TEXTURE CRISTALLOGRAPHIQUE OBTENUE PAR FUSION PAR FAISCEAU ÉLECTRONIQUE

(30) Priority: 04.11.2013 US 201361899713 P
(43) Date of publication of application: 14.09.2016
(73) Proprietor: Raytheon Technologies Corporation, Farmington, CT 06032 (US)
(72) Inventor: DAS, Gopal, Simsbury, CT 06070 (US); CERNATESCU, Luliana, Glastonbury, CT 06033 (US); SHAH, Dilip, M., Glastonbury, CT 06033 (US)
(74) Representative: Dehns
(86) International application number: PCT/US2014/062581
(87) International publication number: WO 2015/108599

(56) References cited:
- JP-A- H0 292 888
- US-A- 5 314 000
- US-A- 5 314 000
- US-A1- 2008 135 530
- US-A1- 2009 162 205
- US-A1- 2011 135 952
- US-A1- 2011 135 952
- US-A1- 2013 206 352
- None

## Description

### BACKGROUND OF THE INVENTION

### 1. Field of the Invention

The present disclosure relates to rapid prototyping alloys, such as for use in aerospace applications.

### 2. Description of Related Art

Rapid-prototyping or additive-layer manufacturing technologies employ a variety of techniques for the fabrication of small parts with complicated shapes. Electron beam melting (EBM), electron beam solid freeform fabrication, epitaxial laser beam forming, laser engineered net shaping (LENS), spray forming, three-dimensional printing, and shaped metal deposition using metal inert gas welding are some techniques currently employed for the fabrication of metal products. These techniques are particularly useful for the fabrication of nickel-based superalloy products and other alloys.

However, the current methods are unable to control the microstructure of the metal formations within each layer. This lack of control leads to lower moduli which leads to greater wear and

US 2011/0135952 discloses a method of forming an article from metal powders. US 5 314 000 discloses a method for controlling the grain size distribution in cast metal articles.

As such, a need exists for a rapid prototyping /multilayer manufacturing technique which provides crystallographic texture controlled microstructures.

### SUMMARY OF THE INVENTION

In one aspect, a process for the preparation of a superalloy metal includes the steps of
providing a metal alloy powder composition;
providing a seed crystal;
processing the metal alloy powder composition in the presence of the seed crystal to provide a superalloy metal having a highly textured or single crystal microstructure; and characterised in that the processing step is performed by electron beam melting.

In certain embodiments, the process for the preparation of a superalloy metal according to the invention further comprises providing an inoculant prior to the processing step to provide a texture-free microstructure.

In certain embodiments, the process for the preparation of a superalloy metal according to the invention further comprises subjecting the superalloy metal, after processing, to heat treatment, hot isostatic pressing (HIP), or both. In embodiments where the after processing steps are performed the heat treatment and the hot isostatic pressing can be performed in any order.

In other particular embodiments, the iron powder comprises austenitic iron.

In still other embodiments, the metal alloy powder composition comprises a powder of Inconel 718, Inconel 600, Inconel 625, Inconel X-750, or Inconel 100.

In a specific embodiment, the metal alloy powder composition comprises a powder of Inconel 718.

In certain other embodiments, the seed crystal is in the form of a single crystal superalloy plate upon which the processing step is performed.

In still other embodiments, seed single crystal has a (111), (110), or (100) orientation gamma microstructure.

In certain embodiments in which an inoculant is used, the inoculant is an oxide or iron based inoculant. In particular embodiments, the inoculant is Co₃FeNb₂, CrFeNb, CoAl₂O₄, or combinations thereof.

In another aspect, the invention provides a superalloy metal formed by the process according to the invention.

In yet another aspect, the invention provides an article comprising a superalloy metal formed by the process according to the invention.

### BRIEF DESCRIPTION OF THE DRAWINGS

So that those skilled in the art to which the subject disclosure appertains will readily understand how to make and use the devices and methods of the subject disclosure without undue experimentation, preferred embodiments thereof will be described in detail herein below with reference to certain figures, wherein:
Figure 1 is a schematic diagram of Arcam electron beam melting unit. [Reference: Silvia Sabbadini, Oriana Tassa, P. Gennaro, and Ulf Ackelid, "Additive Manufacturing of Gamma Titanium Aluminide Parts by Electron Beam Melting", TMS February 1, 2010]. The X-axis and Y axis are defined such that Y axis is in the direction of part growth or parallel with electron beam. X-axis is perpendicular to electron beam direction.

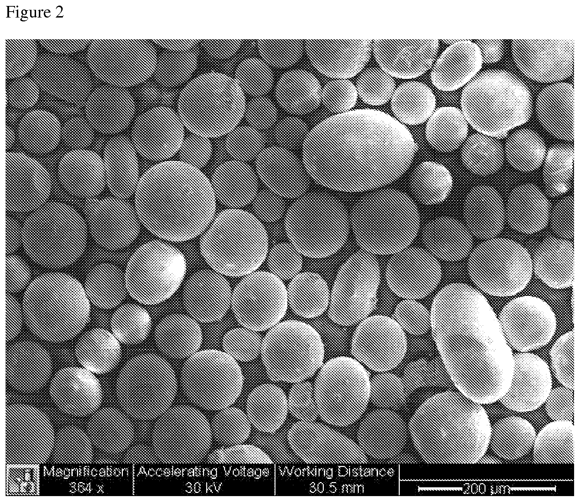

Figure 2 shows an SEM image of the typical precursor IN 718 alloy powder.

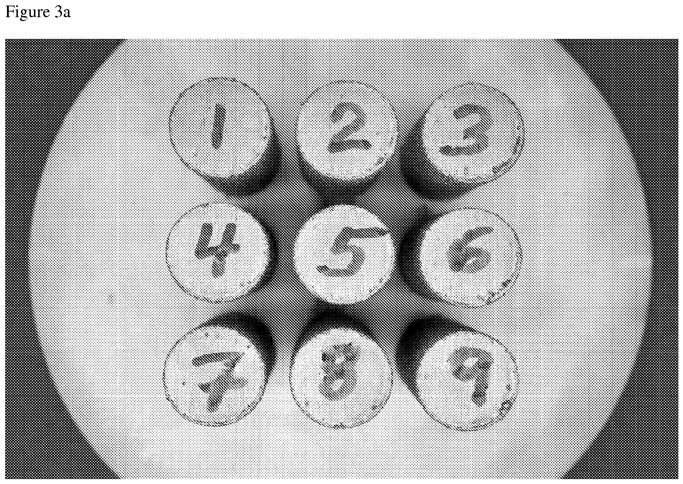

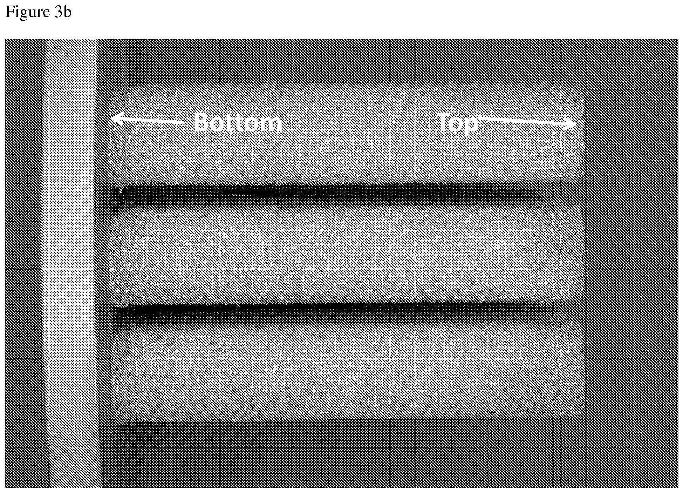

Figure 3a shows a top view IN 718 rods (∼1.9 cm-dia x 10 cm long (∼0.75"-dia x 4" long)) made by EDM additive manufacturing using precursor IN 718 alloy powder on a heated stainless steel plate in vacuum backfield with helium. Figure 3b shows a side view showing the coarse surface finish of the rods produced.
Figure 4 shows schematically the nomenclature of planar (transverse) and axial (longitudinal) sections of the rod.
Figure 5 shows the microstructure (optical photomicrograph) of an as-processed rod along the axial (longitudinal) and transverse (planar) sections.
Figure 6 shows EBM IN718, as processed, showing blocky gamma prime and platelet-like delta precipitates in a gamma matrix. Transverse section. BSEI.
Figure 7 shows an X-ray diffraction pattern of as-processed IN 718 along the planar (transverse) section.
Figure 8 shows the X-ray diffraction pattern from an as-processed IN 718 along the longitudinal (axial) section.
Figure 9 shows the (001) and (111) pole figures from the planar section of EBM IN 718 measured by x-ray diffraction.
Figure 10 shows the reduction of crystallographic texture in the EBM IN718 upon heat treatment.
Figure 11 shows the reduction of crystallographic texture in the EBM IN718 upon heat treatment.
Figure 12 shows a nearly homogenous microstructure of EMB IN 718 resulting from hot isostatic pressing (HIP); longitudinal section (a) and transvers section (b)
Figure 13 shows a nearly homogenous microstructure of EMB IN 718 resulting from hot isostatic pressing (HIP) followed by standard IN718 treatment; longitudinal section (a) and transverse section (b).
Figure 14 shows the X-ray diffraction patterns from both axial (longitudinal) and transverse (planar) sections of the EBM IN718 following hot isotactic pressing and standard IN718 heat treatment.
Figure 15 shows the Crystallographic orientation of major component {100}<001> with respect to the component axis.

### DETAILED DESCRIPTION

### Definitions

As used herein the term "superalloy" refers to a high-performance alloy exhibits excellent mechanical strength and resistance to creep at high temperatures; good surface stability; and corrosion and oxidation resistance. Superalloys typically have a matrix with an austenitic face-centered cubic crystal structure. Without limitation, examples of superalloys are Hastelloy, Inconel (e.g. IN100, IN600, IN713, IN718), Waspaloy, Rene alloys (e.g. Rene 41, Rene 80, Rene 95, Rene N5), Haynes alloys, Incoloy, MP98T, TMS alloys, and CMSX (e.g. CMSX-4) single crystal alloys.

As used herein the term "seed crystal" refers to a superalloy metal crystal having a single crystal microstructure. In certain embodiments, the seed crystal is a discrete metal single crystal. In other embodiments, the seed crystal is the superalloy plate upon which the superalloy metal is formed.

As used herein the term "highly textured" refers to a superalloy metal having greater than 50% of a particular crystallographic texture component. In certain embodiments, the term highly textured refers to a superalloy metal having greater than 55%, greater than 60%, greater than 65%, greater than 70%, greater than 75%, greater than 80%, greater than 85%, greater than 90%, or greater than 95% of a particular crystallographic texture component.

As used herein the term "single crystal" refers to a superalloy metal having a particular crystal microstructure without a grain boundaries.

As used herein, the term "texture-free" or "equiaxed" refers to a superalloy metal having crystals of approximately the same length and shape with random grains/crystallites orientation.

### Electron Beam Melting

Electron beam melting (EBM) is a powder-bed, additive manufacturing technique which creates nearly fully dense metal parts directly from a computer CAD model. Pre-deposited metal powder is selectively melted layer-by-layer using a focused electron beam under high vacuum. The process starts with the deposition of a thin layer of powder on a build plate. An electron beam with a defined intensity is then scanned across the surface at points that correspond to the cross-section of the component. The process uses the kinetic energy of electrons to heat up and melt metal powders creating a melt pool that causes localized bonding between powder particles. As the electron moves away from the melt pool, the molten material is solidified forming a fully dense structure. Each layer is melted deeply enough to fuse it to the underlying layer. Another layer of powder material is then spread onto the previously melted layer and the process is repeated. During the build cycle, the vacuum system is kept at ∼1x 10-5 mbar or better; in addition, during the actual melting a partial pressure of He is maintained at 2 x 10-3 mbar. The EBM process is conducted at high temperature in order to stress relieve the components.

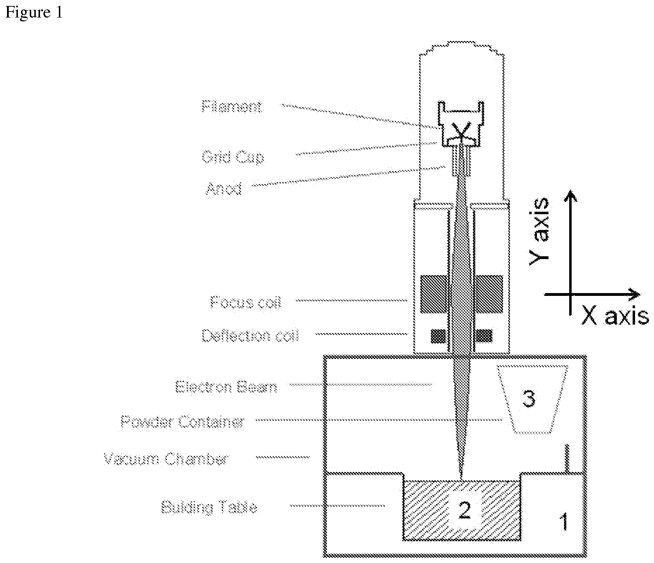

Typical EBM system is shown in Figure 1. This is an Arcam EBM system. Using this system IN 718 alloy precursor powder is stored in a container (3 in Figure 1). The powder is gravity fed it onto the building component (2 in Figure 1) resting on a stainless steel build table (1 in Figure 1), where powder is racked into layers roughly 210 microns thick. A tungsten filament is heated by running a current through it. A potential of 60 kV creates an electric field which accelerates the free electrons off of the filament towards the coil at speeds of around 0.6 c, where c is the velocity of light in vacuum. The control of the electron beam is accomplished by the focus coil, which squeezes the beam to the appropriate size, and then by the deflection coil the beam is pointed towards the powder layer on the build plate. The electron beam is scanned across the powder layer (2 in Figure 1) by a computer -aided design system. The beam is initially scanned at high rate in multiple passes to preheat the powder, and a melt scan at (∼102 mm/sec) and 10 mA beam current selectively melts the raked layer to a thickness of ∼210 microns (roughly 3 times the average particle layer). A new layer is then racked and the process repeated, producing an additive layered monolithic build.

### Process of the Invention

The invention provides a process for the preparation of a superalloy metal comprising the steps of:
providing a metal alloy powder composition;
providing a seed crystal of a superalloy metal;
processing the metal alloy powder composition in the presence of the seed crystal to provide a superalloy metal having a highly textured or single crystal microstructure.

The metal alloy powered composition is processed by electron beam melting,

In general, the processing of the superalloy metal is performed on a superalloy plate in the presence of a vacuum. In certain embodiments, the plate is a stainless steel plate. In other embodiments the plate is kept at about 910 ± 20 C during the processing.

The electron beam melting process operates at an elevated temperature; without limitation, between 500 and 2000 °C, between 600 °C and 1500, or between 700 and 1000 °C. In certain embodiments where a superalloy plate is used in the processing step, the superalloy plate is also used at an elevated temperature; without limitation, between 500 and 2400 °C, between 700 °C and 2000, between 1000 and 1500 °C, or between 1200 and 1400 °C,

In certain other embodiments where electron beam melting is used, the melt rate of the electron beam melting process is, without limitation, from 0.1 to 100 cm³/h, from 0.5 to 90 cm³/h, or from 1 to 80 cm³/h.

The process of the invention may be used to produce superalloy metal materials and articles having a crystal microstructure which varies from highly textured to single crystal textured. The crystal microstructure can be controlled by the inclusion of one or more seed crystals having a single crystal orientation. Crystal orientations are referred to, in general, by their Miller Index. The crystal orientation of the seed crystal may be such that Y direction shown in Figure 1 is parallel with any of the following crystallographic orientations, without limitation, <100>, <010>, <001>, <110>, <011>, <101>, <-110>, <0-11>, <-101>,<111>, <-111>, <1-11>, <11-1>, <102>, <-102>, or <200>. Thus, the resulting superalloy metal will have a microstructure orientation such that the part growth direction is parallel with one of the following crystallographic orientations, without limitation, of <100>, <010>, <001>, <110>, <011>, <101>, <-110>, <0-11>, <-101>, <111>, <-111>, <1-11>, <11-1>, <102>, <-102>, or <200>. In certain embodiments, the seed crystal may be provided in the form of a single crystal superalloy plate upon which the metal is formed during the processing step.

In certain embodiments, the process for the preparation of a superalloy metal according to the invention further comprises subjecting the superalloy metal, after processing, to heat treatment, hot isostatic pressing (HIP), or both. Such after processing steps provide increased control over the ultimate texture/microstructure as well as the ductility and creep resistance. In embodiments where the after processing steps are performed the heat treatment and the hot isostatic pressing can be performed in any order.

Such heat treatment can be performed using standard methods known in the art, for example, and without limitation, the methods of DeAntonio - ASM International, ASM Handbook, 1991; or Harf (US 4,676,846). In general, and without limitation, heat treatment is performed at 750-2500°F for about 15 minutes - 3 hours. In certain embodiments, heat treatment is performed at 1000-2200°F, 1500-2000°F, or 1800-1900°F,for about 30 minutes - 2 hours, about 45 minutes - 90 minutes, or about 1 hour.

Similarly, such hot isostatic pressing can be performed using standard methods known in the art, for example, and without limitation, the methods of ASTM A1080-12; ASTM A989 / A989M - 13; DeAntonio - ASM International, ASM Handbook, 1991; Neil (U.S. 4,952,353), or HT Larker, R Larker - Materials Science and Technology, 1991.

In general, and without limitation, hot isostatic pressing is performed at 500-2500°C and 5-25 ksi, for about 30 minutes - 8 hours. In certain embodiments, heat treatment is performed at 750-2000°C, 1000-1500°C, or 1100-1200°C; and at 10-20ksi, 12-17 ksi, or about 15ksi; for a about 1 hour - 6 hours, about 3 hours - 5 hours, or about 4 hours.

Articles of superalloy metal materials may be formed by manufacturing layers of superalloy metal by the process of the invention on top of each other in a layer-by-layer approach.

In other embodiments where a layer-by-layer approach is used, the minimum layer thickness is, without limitation, 0.01 mm, 0.025 mm, or 0.05mm.

Specific articles which may be formed by the process of the invention include, but are not limited to, turbine blades, crystal blades, turbine vanes, turbine blade outer air seals, turbine rotors, combustor components, components for space vehicles; components for submarines; components for nuclear reactors; components for electric motors; components for high-performance vehicles, chemical processing vessels, bomb casings and heat exchanger tubing.

### Inoculants

In certain embodiments, the process of the invention can be used to provide a superalloy metal having a texture-free or equiaxed microstructure.

In such embodiments, the process of the invention further includes the use of an inoculant prior to the processing step. Such inoculants include, but are not limited to iron containing inoculants or oxide inoculants. Particular inoculants are, but are not limited to, Co₃FeNb₂, CrFeNb, CoAl₂O₄, or combinations thereof .

In certain embodiments, the amount of inoculant added to the metal alloy powder to produce the texture-free microstructure is present in a an amount of 0.1 wt% - 5 wt% based on the total weight of the metal powder and inoculants.

Without being limited by theory, it is believed that the inoculants act as nucleation sites to thereby suppress the formation of a microstructure texture. The resulting superalloy metal is substantially texture-free or has a weak texture, which would correspond to any texture components having volume fraction below about 20%.

### Metal Alloy Powder Composition

The process of the invention utilizes one or more metal or metal alloy powders for the preparation of the superalloy metal having the defined microstructure.

Such metal and metal alloy powders comprise, without being limited to, powders comprising iron, nickel, chromium, molybdenum, niobium, cobalt, manganese, copper, aluminum, titanium, silicon, carbon, sulfur, phosphorous, boron, tantalum or a combination thereof.

In certain embodiments, the metal alloy powder comprises a combination of iron, nickel, and chromium. In particular embodiments, the iron / iron alloy powder comprises austenitic iron.

In still other embodiments, the metal alloy powder composition comprises a powder of Inconel 718, Inconel 600, Inconel 625, Inconel X-750, or Inconel 100.

In particular, the metal alloy powder composition comprises an Inconel alloy powder having the following elemental makeup:

| **Inconel** | **Element (% by mass)** | | | | | | | | | | | | | | | | |
|---|---|---|---|---|---|---|---|---|---|---|---|---|---|---|---|---|---|
| | **Ni** | **Cr** | **Fe** | **Mo** | **Nb** | **Co** | **Mn** | **Cu** | **Al** | **Ti** | **Si** | **C** | **S** | **P** | **B** | **V** | **Zr** |
| 600^{[4]} | 72.0 | 14.0- 17.0 | 6.0- 10.0 | | | | 1.0 | 0.5 | | | 0.5 | 0.15 | 0.015 | | | | |
| 617 ^{[5]} | 44.2-56.0 | 20.0- 24.0 | 3.0 | 8.0-10.0 | | 10.0-15.0 | 0.5 | 0.5 | 0.8-1.5 | 0.6 | 0.5 | 0.15 | 0.015 | 0.015 | 0.006 | | |
| 625 ^{[6]} | 58.0 | 20.0- 23.0 | 50 | 8.0-10.0 | 13.15-4.15 | 1.0 | 0.5 | | 0.4 | 0.4 | 0.5 | 0.1 | 0.015 | 0.015 | | | |
| 718 ^{[7]} | 50.0-55.0 | 17.0- 21.0 | balance | 2.8-3.3 | 4.75-5.5 | 1.0 | 0.35 | 0.2-0.8 | 0.65-1.15 | 0.3 | 0.35 | 0.08 | 0.015 | 0.015 | 0.006 | | |
| X-750 ^{[8]} | 70.0 | 14.0- 17.0 | 5.0-9.0 | | 0.7-1.2 | 1.0 | 1.0 | 0.5 | 0.4-1.0 | 2.25-2.75 | 0.5 | 0.08 | 0.01 | | | | |
| 100 | 60.705 | 9.5 | | 3.3 | | 15 | | | 5.5 | 4.75 | | 0.17 | | | 0.015 | 1.0 | 0.06 |

The size of the superalloy metal powder is not generally limited. In certain embodiments, the superalloy metal powder has particle sizes ranging from about 5µm to about 500µm, from about 25µm to about 400µm, or from about 40µm to about 200µm. In specific embodiments, the superalloy metal powder has a powder size range from -120 mesh to +325 mesh with a mean powder size of 80 microns. Similarly, the surface area of the superalloy metal powder is not generally limited. In certain embodiments, the superalloy metal powder has a BET surface area from about 1 to 10 m²/g, from about 2.5 to 7.5 m²/g, or from about 4.5 to about 6.0 m²/g.

The bulk density of the dry superalloy metal powder is not generally limited. In certain embodiments, the superalloy metal powder has a dry bulk density from about 0.1 to 2.0 g/cm3, from about 0.3 to 1.5 g/cm3, from about 0.5 to 1.2 g/cm3, from about 0.3 to 0.8 g/cm3, or from from about 0.5 to 0.7 g/cm3.

### Examples

### Preparation of Cylindrical Rods of Inconel 718 having a {100}<001> crystallographic orientation.

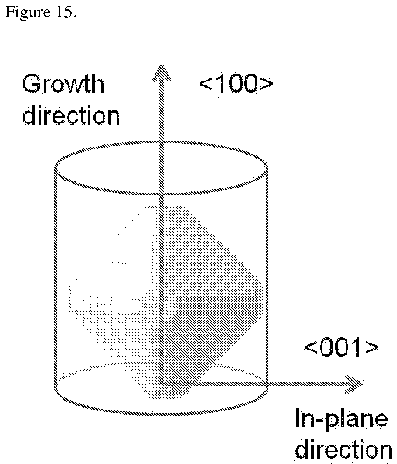

Cylindrical IN718 rods (1.9 cm-dia x 10 cm long (0.75"-dia x 4" long)) were built layer by layer using IN 718 powders by electron beam melting on a heated stainless steel plate in vacuum. The chemical analysis of the EBM IN 718 rods is : 52.91 Ni- 18.74 Cr- 19.23 Fe- 3.09 Mo- 4.89 Nb- 0.16 Co- <0.01 Mn- 0.01 Cu- 0.44 Al- 0.88 Ti- 0.03Si- 0.01C- 0.002 P- 0.001 B- <0.01N, - 0.010- <0.01 Ta (all in wt.%). Crystallographic texture components analysis showed strong crystallographic texture with <100> crystallographic direction of the gamma matrix being parallel with the growth direction for the electron beam melting process. The development of {100} <100> textured microstructure during the electron beam melting additive manufacturing process is commonly explained in terms of <100> being the easy growth direction of face centered cubic (fcc) gamma matrix. Figure 15 shows the crystallographic directions with respect to sample/part axis.

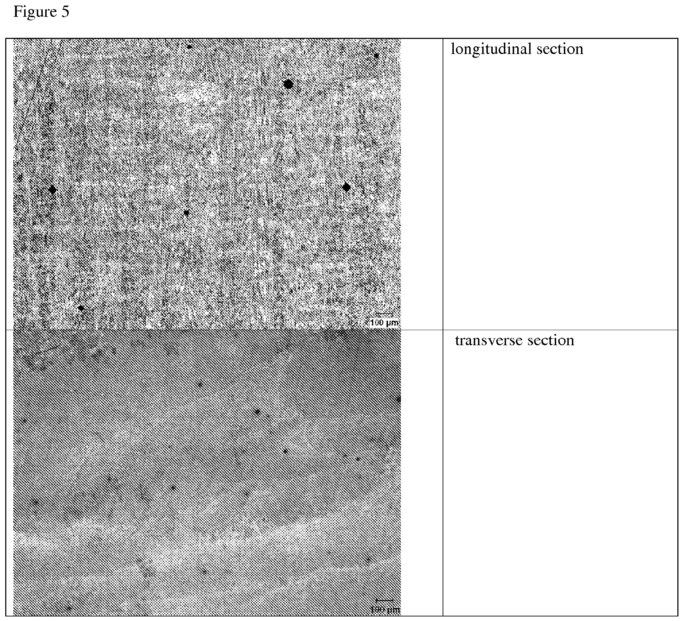

Figure 5a shows the microstructure (optical photomicrograph) of an as-processed rod along the axial (longitudinal) direction. It consists of dendrites primarily aligned parallel to the growth direction. The thickness of the layer produced by successive scanning and is measured to be ∼250 micrometers (∼250 microns). Some large pores are readily seen between two layers. Figure 5b shows the microstructure of an as-processed rod along the planar (transverse) direction. It shows the relative width of the individual scanned layer which is measured to be ∼300 micrometers (∼300 microns). Numerous rod-like delta phase precipitates are found along with globular gamma prime. However, no gamma double prime precipitates are found as they are too small to be resolved. The average hardness values for these two orientations are similar and determined to be 29 HRC.

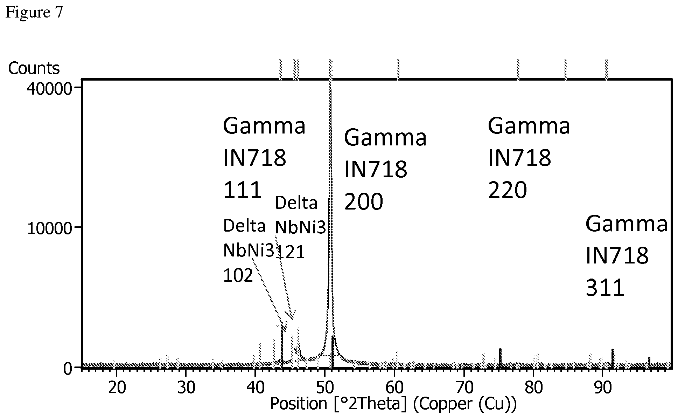

Figure 7 shows an X-ray diffraction pattern of as-processed IN 718 along the planar (transverse) section. The following phases are identified:
Nickel -fcc (gamma matrix), Ni3(Al,Ti) - L12 (gamma prime),
Ni3 (Nb, Ti) -DO22 (gamma double prime) and Ni3(Nb, Ti)-DOa (delta phase).

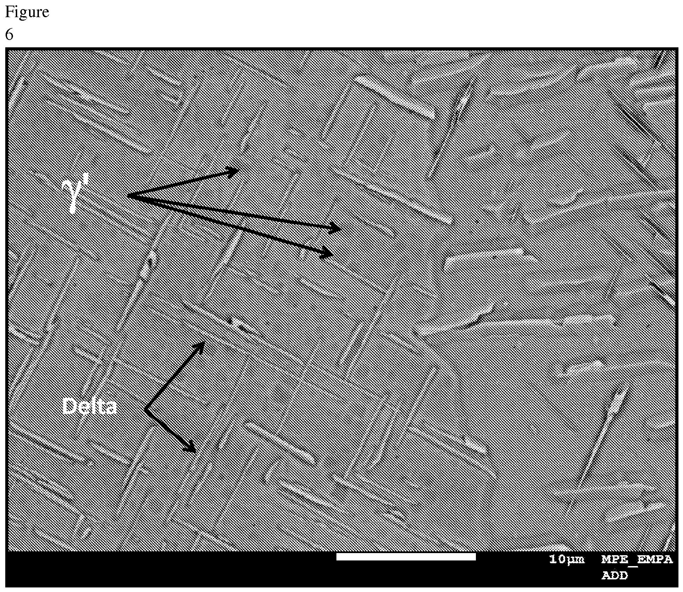

The planar section data indicate 100 texture (100 crystallographic direction is parallel to the growth direction). The peak intensity suggests a relatively high volume fraction of delta-phase precipitates as supported by mimcro-structure image in Figure 6.

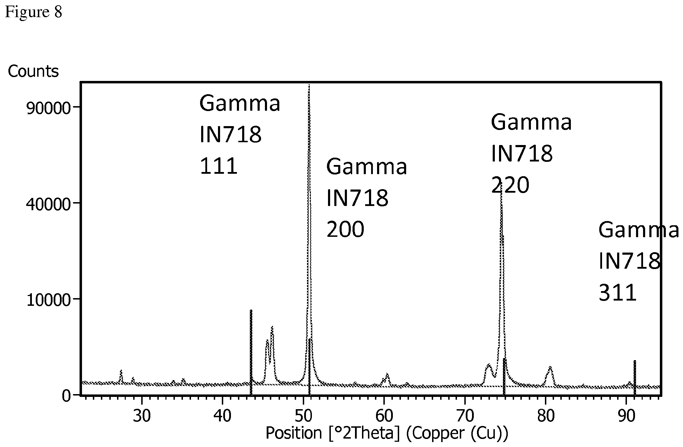

Figure 8 shows the X-ray diffraction pattern from an as-processed IN 718 along the longitudinal (axial) section. The major reflections are 200 and 220 of the gamma matrix. The data indicate that <001> crystallographic direction of the gamma phase is perpendicular to the longitudinal (axial) section.

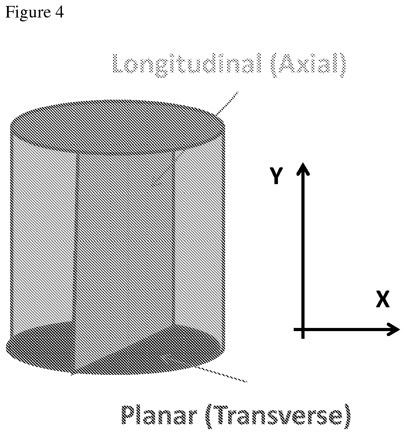

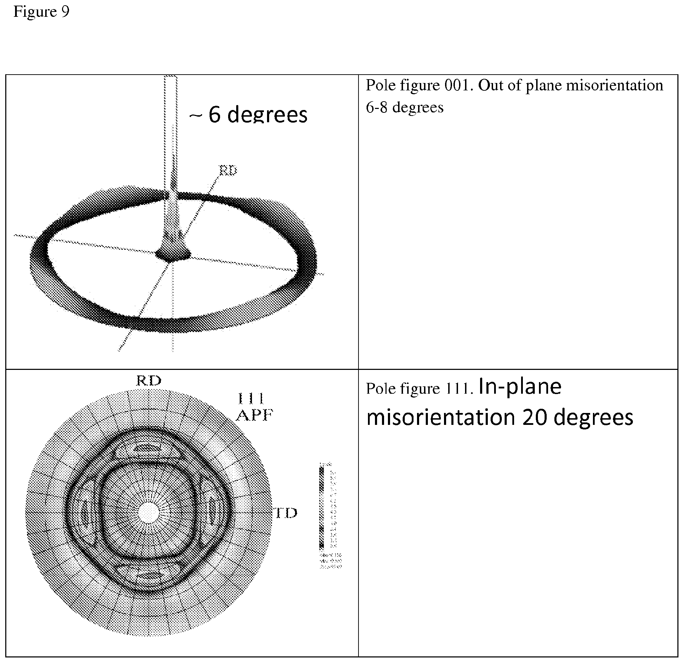

The pole figures from the planar section of EBM IN 718 measured by x-ray diffraction pattern are shown in figure 9. Analysis of the texture data indicates high crystallographic texture with the major component as {100} <001> type with 65 +-5% volume fraction and the remaining volume fraction is random or other components with small volume fraction (<5%). The grains are aligned such that theirs <100> crystallographic direction is within 6-8 degrees spread from the growth direction denoted as Y in figure 1 and 4. The <001> crystallographic direction is within 10-20 degrees mozaic spread.

### Heat Treatment of Cylindrical Rods of Inconel 718 having a (100) crystallographic texture.

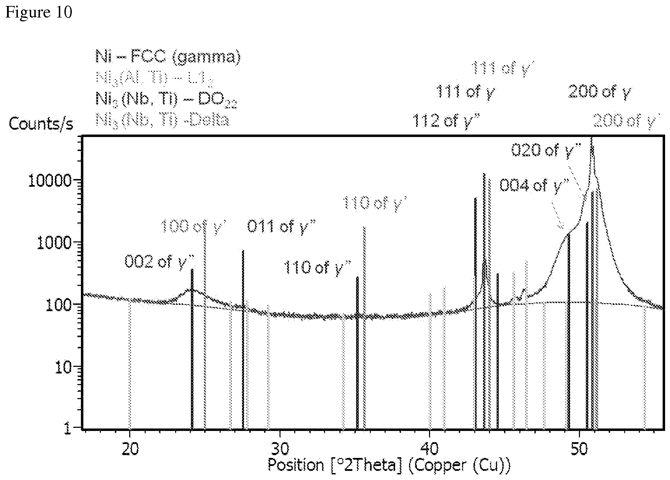

Heat treatment of as-processed EBM IN 718 rods at 1040°C/hr (1900F/1hr) + standard IN 718 solution & precipitation heat treatment resulted in gradual reduction in texture and introduced grain coarsening with little delta phase being present as shown in Figure 10 (data collected on transverse section).

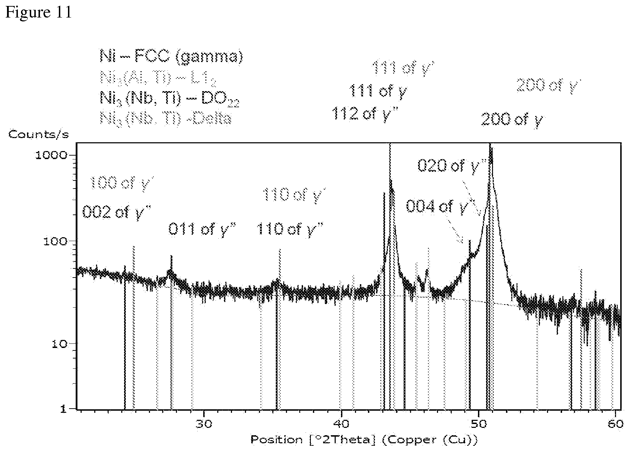

Figure 11 shows diffraction data in axial/longitudinal specimen of EBM IN718 following 1900F + standard IN718 heat treatment. The corresponding X-ray diffraction pattern indicates reduction of texture.

### Hot Isostatic Pressing (HIP) and Heat Treatment of Cylindrical Rods of EBM IN 718 having a (100) crystallographic texture.

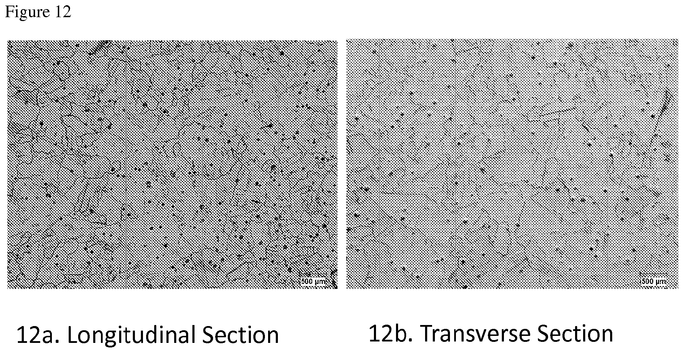

The as-processed EMB IN 718 rods were subjected to hot isostatic pressing (HIP) at 1163°C/100 MPa/4hr (2125F/15 ksi/4hr). In general, there is an overall reduction of porosity and considerable grain coarsening. The average grain size was larger than ASTM 1 as shown in Figure 12a and b. The hardness values for both transverse (planar) and longitudinal (axial) sections were the same∼30.5 RC.

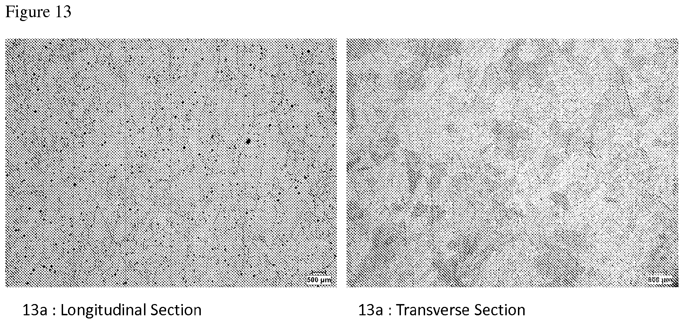

The as-hip'd rods were subjected to the standard IN 718 solution and precipitation heat treatment. Figure 13 shows the microstructures for both transverse (planar) and longitudinal (axial) sections. Numerous fine pore are still present. The hardness values are the same for both orientations ∼44 RC.

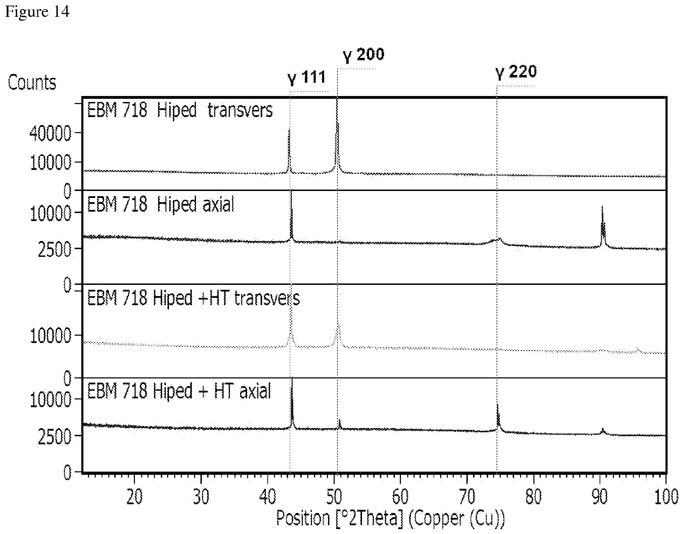

Figure 14 shows the X-ray diffraction patterns from both axial/longitudinal and transverse/planar section of as-hip'd and heat treated IN 718 rods.

Figure 14 indicates presence of large crystallites (above 200 microns) in both HIP'ed and HIP'ed + heat treated conditions. Texture analysis has shown low crystallographic texture.

### Mechanical Properties of hip'd & heat treated EBM IN 718 rods

### a. Tensile Properties:

Tensile tests were conducted on Hip'd and heat treated EBM 718 specimens at RT & 1200F (see tables A and Bbelow).

**Table A: Tensile Properties of Hip'ed and Heat Treated EBM 718**

| Specimen ID | Temp/C (F) | UTS/MPa (ksi) | YS/MPa (ksi) | Elongation (%) | Remarks |
|---|---|---|---|---|---|
| EBM718*:Hip'ed + HT | RT | 1160 (168) | 1010 (147) | 17 | GS ASTM 1 and coarser (250-400 micrometers) |
| EBM718*:Hip'ed + HT | 650 (1200) | 862 (125) | 779 (113) | 18 | GS ASTM 1 and coarser (250-400 micrometers) |
| Conventional 718 | RT | 1340 (195) | 1100 (160) | 12 | GS ASTM 6 (45 micrometer) |
| Conventional 718 | 650 (1200) | 1100 (160) | 931 (135) | 12 | GS ASTM 6 (45 micrometer) |

| | | | | | |
|---|---|---|---|---|---|
| * Hip'ed at 1163C/100 MPa/4 hr (2125F/15 ksi /4h)+ Post HIP Heat treatment: (a)Solution HT: 950±14C (1750±25F)/1hr-5 min/+15 min suitable protective atmosphere (Ar, He, VAC). Air Cool or Faster (b)Aging Precip HT: 991±14C (1325±25F) 8 hr ±24 min, suitable protective atmosphere (Ar, He, VAC), Furnace cool to 895C+895±14C (1150F+1150±25F)/8 hr±24 min, suitable protective atmosphere (Ar, He, VAC), Air Cool or Faster | | | | | |

**Table B: Tensile Properties of Hip'ed and Heat Treated EBM 718**

| Specimen ID | Temp (F) | UTS/MPa (ksi) | YS_{/MPa} (ksi) | Elongation (%) | Remarks |
|---|---|---|---|---|---|
| EBM718*:Hip'ed + HT (P&W data) | RT | 1160 (168) | 1010 (147) | 17 | GS ASTM 1 and coarser (250-400 microns) |
| EBM718*:Hip'ed + HT (P&W data) | 650 (1200) | 862 (125) | 779 (113) | 18 | GS ASTM 1 and coarser (250-400 microns) |
| Conventional 718 | RT | 1340 (195) | 1100 (160) | 12 | GS ASTM 6 (45 micron) |
| Conventional 718 | 650 (1200) | 1100 (160) | 931 (135) | 12 | GS ASTM 6 (45 microns) |

| | | | | | |
|---|---|---|---|---|---|
| * Hip'ed at 1163C/100 MPa/4 hr (2125F/15 ksi /4h) + Post HIP Heat treatment: (a)Solution HT: 950±14C (1750±25F)/1hr-5 min/+15 min suitable protective atmosphere (Ar, He, VAC), Air Cool or Faster (b)Aging Precip HT: 991±14C (1325±25F) 8 hr ±24 min, suitable protective atmosphere (Ar, He, VAC), Furnace cool to 895C+895±14C (1150F+1150±25F)/8 hr±24 min, suitable protective atmosphere (Ar, He, VAC), Air Cool or Faster | | | | | |

### b. Creep properties of hipre and Heat Treated EBM IN 718

A few specimens were tested in creep test at 920C/550 MPa (1200F/80 ksi). The creep life is somewhat lower than the conventional IN718.

### Preparation of Cylindrical Rods of EBM IN718 having a (111) crystallographic texture.

To produce a highly (111) textured or single crystal gamma microstructure in IN718 during the electron beam melting a(111) oriented single crystal plate as a seed can be used. It is known that in superalloys, crystals with <111> orientation yield the highest modulus and those with <100> provide the lowest modulus. Thus, a highly (111) textured material may replace single crystal with (111) orientation provided the property goals are met with the textured material.

To that end, cylindrical IN718 rods 1.9 cm-dia x 10 cm long (0.75" -dia x 4" long) are built layer by layer using IN 718 powders by electron beam melting on a heated (111) single crystal superalloy plate in vacuum.

### Preparation of Cylindrical Rods of EBM IN718 having an equiaxed crystallographic texture.

To produce a equiaxed, or texture-free, microstructure one or more inoculants are utilized with in IN718 during the electron beam melting by using (111) single crystal plate as a seed.

To that end, cylindrical IN718 rods 1.9 cm -dia x 10 cm long (0.75" -dia x 4" long) are built layer by layer using a mixture of IN 718 powder and CO₃FeNb₂, CrFeNb, or CoAl₂O₄. The rods are built by electron beam melting on a heated superalloy plate in vacuum.

### Preparation of turbine blade of Inconel 718 having a (100) crystallographic texture.

Jet engine turbine blades of IN718 1.9 cm -dia x 10 cm long (0.75" -dia x 4" long) are built layer by layer using IN 718 powders by electron beam melting on a heated superalloy plate in vacuum as described for the cylindrical rods above.

### Preparation of rotors of EBM IN718 having a (100) crystallographic texture.

Rotors of IN718 1.9 cm -dia x 10 cm long (0.75" -dia x 4" long) are built layer by layer using IN 718 powders by electron beam melting on a heated stainless steel plate in vacuum as described for the cylindrical rods above.

## Claims

1. A process for the preparation of a superalloy metal comprising the steps of providing a metal alloy powder composition;
providing a seed crystal;
processing the metal alloy powder composition in the presence of the seed crystal to provide a superalloy metal having a highly textured or single crystal microstructure; **characterised in that** the processing step is performed by electron beam melting.

2. The process for the preparation of a superalloy metal according to Claim 1, further comprising:
providing an inoculant prior to the processing step to provide a texture-free microstructure, wherein the inoculant is Co₃FeNb₂, CrFeNb, CoAl₂O₄, or combinations thereof.

3. The process for the preparation of a superalloy metal according to Claim 1, further comprising the step of:
subjecting the superalloy metal to heat treatment.

4. The process for the preparation of a superalloy metal according to Claim 1, further comprising the step of:
subjecting the superalloy metal to hot isostatic pressing (HIP).

5. The process for the preparation of a superalloy metal according to Claim 1, further comprising the steps of:
subjecting the superalloy metal to heat treatment, and
subjecting the superalloy metal to hot isostatic pressing (HIP).

6. The process for the preparation of a superalloy metal according to Claim 1, wherein the metal alloy powder composition comprises iron, nickel, chromium, molybdenum, niobium, cobalt, manganese, copper, aluminum, titanium, silicon, carbon, sulfur, phosphorous, boron, tantalum, tungsten, or a combination thereof.

7. The process for the preparation of a superalloy metal according to Claim 6, wherein the iron powder comprises austenitic iron.

8. The process for the preparation of a superalloy metal according to Claim 6, wherein the metal alloy powder composition comprises a powder of Inconel 718, Inconel 600, Inconel 625, Inconel X-750, or Inconel 100.

9. The process for the preparation of a superalloy metal according to Claim 1, wherein the seed crystal has a (111), (110), or (100) textured gamma micro structure.

## Patentansprüche

1. Prozess zur Herstellung eines Superlegierungsmetalls, umfassend die folgenden Schritte:
Bereitstellen einer Metalllegierungspulverzusammensetzung;
Bereitstellen eines Impfkristalls;
Verarbeiten der Metalllegierungspulverzusammensetzung in Gegenwart des Impfkristalls, um ein Superlegierungsmetall bereitzustellen, das eine stark strukturierte oder Einkristall-Mikrostruktur aufweist;
**dadurch gekennzeichnet, dass** der Verarbeitungsschritt durch Elektronenstrahlschmelzen durchgeführt wird.

2. Prozess zur Herstellung eines Superlegierungsmetalls nach Anspruch 1, ferner umfassend:
Bereitstellen eines Impfmittels vor dem Verarbeitungsschritt, um eine strukturfreie Mikrostruktur bereitzustellen, wobei es sich bei dem Impfmittel um Co₃FeNb₂, CrFeNb, CoAl₂O₄, oder Kombinationen davon handelt.

3. Prozess zur Herstellung eines Superlegierungsmetalls nach Anspruch 1, ferner umfassend den folgenden Schritt:
Unterziehen des Superlegierungsmetalls einer Wärmebehandlung.

4. Prozess zur Herstellung eines Superlegierungsmetalls nach Anspruch 1, ferner umfassend den folgenden Schritt:
Unterziehen des Superlegierungsmetalls einem heißisostatischen Pressen (HIP).

5. Prozess zur Herstellung eines Superlegierungsmetalls nach Anspruch 1, ferner umfassend die folgenden Schritte:
Unterziehen des Superlegierungsmetalls einer Wärmebehandlung, und
Unterziehen des Superlegierungsmetalls einem heißisostatischen Pressen (HIP).

6. Prozess zur Herstellung eines Superlegierungsmetalls nach Anspruch 1, wobei die Metalllegierungspulverzusammensetzung Eisen, Nickel, Chrom, Molybdän, Niob, Cobalt, Mangan, Kupfer, Aluminium, Titan, Silicium, Kohlenstoff, Schwefel, Phosphor, Bor, Tantal, Wolfram, oder eine Kombination davon umfasst.

7. Prozess zur Herstellung eines Superlegierungsmetalls nach Anspruch 6, wobei das Eisenpulver austenitisches Eisen umfasst.

8. Prozess zur Herstellung eines Superlegierungsmetalls nach Anspruch 6, wobei die Metalllegierungspulverzusammensetzung ein Pulver von Inconel 718, Inconel 600, Inconel 625, Inconel X-750, oder Inconel 100 umfasst.

9. Prozess zur Herstellung eines Superlegierungsmetalls nach Anspruch 1, wobei der Impfkristall eine strukturierte (111)-, (110)- oder (100)-Gamma-Mikrostruktur aufweist.

## Revendications

1. Procédé de préparation d'un métal de superalliage comprenant les étapes
de fourniture d'une composition de poudre d'alliage métallique ; de fourniture d'un cristal germe ;
de traitement de la composition de poudre d'alliage métallique en présence du cristal germe pour fournir un métal de superalliage ayant une microstructure hautement texturée ou monocristalline ;
**caractérisé en ce que** l'étape de traitement est effectuée par fusion par faisceau électronique.

2. Procédé de préparation d'un métal de superalliage selon la revendication 1, comprenant en outre :
la fourniture d'un inoculant avant l'étape de traitement pour fournir une microstructure sans texture, dans lequel l'inoculant est Co₃FeNb₂, CrFeNb, CoAl₂O₄, ou des combinaisons de ceux-ci.

3. Procédé de préparation d'un métal de superalliage selon la revendication 1, comprenant en outre l'étape :
de soumission du métal de superalliage à un traitement thermique.

4. Procédé de préparation d'un métal de superalliage selon la revendication 1, comprenant en outre l'étape :
de soumission du métal de superalliage à un pressage isostatique à chaud (HIP).

5. Procédé de préparation d'un métal de superalliage selon la revendication 1, comprenant en outre les étapes :
de soumission du métal de superalliage à un traitement thermique, et
de soumission du métal de superalliage à un pressage isostatique à chaud (HIP).

6. Procédé de préparation d'un métal de superalliage selon la revendication 1, dans lequel la composition de poudre d'alliage métallique comprend du fer, du nickel, du chrome, du molybdène, du niobium, du cobalt, du manganèse, du cuivre, de l'aluminium, du titane, du silicium, du carbone, du soufre, du phosphore, du bore, du tantale, du tungstène ou une combinaison de ceux-ci.

7. Procédé de préparation d'un métal de superalliage selon la revendication 6, dans lequel la poudre de fer comprend du fer austénitique.

8. Procédé de préparation d'un métal de superalliage selon la revendication 6, dans lequel la composition de poudre d'alliage métallique comprend une poudre d'Inconel 718, Inconel 600, Inconel 625, Inconel X-750, ou Inconel 100.

9. Procédé de préparation d'un métal de superalliage selon la revendication 1, dans lequel le cristal germe a une microstructure gamma texturée (111), (110) ou (100).
